Europäisches Patentamt

European Patent Office

Office européen des brevets

(19)

(11) EP 0 698 970 B1

(12) **FASCICULE DE BREVET EUROPEEN**

(45) Date de publication et mention
de la délivrance du brevet:
**29.04.1998 Bulletin 1998/18**

(51) Int Cl.⁶: **H03L 7/087**, H04L 27/38,
H04L 27/227

(21) Numéro de dépôt: **95202182.2**

(22) Date de dépôt: **10.08.1995**

(54) **Système de transmission numérique à double boucle de synchronisation**

Digitales Übertragungssystem mit einer doppelten Synchronisierungsschleife

Digital transmission system comprising a double synchronising loop

(84) Etats contractants désignés:
**DE FR GB**

(30) Priorité: **25.08.1994 FR 9410278**

(43) Date de publication de la demande:
**28.02.1996 Bulletin 1996/09**

(73) Titulaires:
- **LABORATOIRES D'ELECTRONIQUE PHILIPS S.A.S.**
  **94450 Limeil-Brévannes (FR)**
  Etats contractants désignés:
  **FR**
- **PHILIPS ELECTRONICS N.V.**
  **5621 BA Eindhoven (NL)**
  Etats contractants désignés:
  **DE GB**

(72) Inventeurs:
- **Martinez, Georges**
  **F-75008 Paris (FR)**
- **Guillaud, Jean-Michel**
  **F-75008 Paris (FR)**

(74) Mandataire: **Landousy, Christian**
  **Société Civile S.P.I.D.**
  **156, Boulevard Haussmann**
  **75008 Paris (FR)**

(56) Documents cités:
  EP-A- 0 461 022          EP-A- 0 592 686
  US-A- 4 794 623          US-A- 4 947 409

- **NACHRICHTENTECHNISCHE BERICHTE, no. 5, Novembre 1988 BACKNANG DE, pages 83-92, XP 000233882 THOMAS ALBERTY ET AL. 'Digitaler Demodulator für den mobilen Satellitenfunk'**

# EP 0 698 970 B1

## Description

L'invention concerne un système de transmission de signaux muni d'un appareil de réception comprenant des moyens de synchronisation de porteuse pour estimer et compenser des défauts de synchronisation entre une porteuse locale et un signal d'entrée modulé, l'appareil comprenant en outre des moyens de démodulation du signal d'entrée qui délivrent un signal démodulé et des moyens de traitement du signal démodulé, les moyens de synchronisation comprenant une première boucle de correction munie d'une part de moyens de détection phase/fréquence pour délivrer un premier signal d'erreur des premiers moyens de filtrage passe-bas ayant une première bande passante pour filtrer le premier signal d'erreur, le premier signal d'erreur filtré corrigeant les défauts de synchronisation en mode d'accrochage, et d'autre part de moyens pour générer la porteuse locale, et une deuxième boucle de correction comprenant des moyens de détection de phase qui délivrent un second signal d'erreur lequel corrige les défauts de synchronisation en mode accroché, des moyens de mixage, disposés entre les moyens de démodulation et les moyens de traitement, pour mélanger le signal démodulé avec un signal de correction de phase, et des moyens pour commander les boucles et pour placer les moyens de synchronisation soit en mode d'accrochage, soit en mode accroché.

Elle concerne également un appareil de réception utilisé notamment dans les systèmes utilisant des modulations codées par sauts de phase (PSK) ou celles par sauts d'amplitude et par sauts de phase (MAQ). De tels systèmes peuvent être utilisés par exemple en télévision numérique ou en téléphonie.

On connaît des dispositifs de récupération de porteuse mettant en oeuvre une boucle de récupération de porteuse comprenant un oscillateur qui est commandé en tension par un signal d'erreur issu de l'écart phase/fréquence qui mesure une désynchronisation entre la porteuse locale fournit par l'oscillateur et la porteuse de l'émission.

Un dispositif de ce type, mais plus sophistiqué, est par exemple décrit dans le document US 4 794 623 qui concerne une récupération de porteuse. Pour obtenir une acquisition rapide de la fréquence et de la phase de la porteuse d'émission, ce dispositif met en oeuvre deux voies de récupération qui ajustent la fréquence et la phase d'un oscillateur local sur la porteuse de l'émission. Dans un premier temps, un détecteur phase/fréquence intervient pour accrocher l'oscillateur local, puis, dans un second temps, un détecteur de phase effectue une synchronisation de phase plus fine.

On connaît également le document intitulé "Digitaler Demodulator für den mobilen Satellitenfunk", Th. ALBERTY et V. HESPELT, publié dans ANT Nachrichtentechnische Berichte (1988) Nov., N° 5, pages 83-92, Backnang. Ce document décrit un système de transmission de signaux muni d'un appareil de réception comportant des moyens de démodulation du signal d'entrée, des moyens de traitement du signal démodulé et des moyens de synchronisation de porteuse. Les moyens de synchronisation comportent une première boucle pour opérer une synchronisation de fréquence et une seconde boucle pour opérer une synchronisation de phase. A partir de signaux d'erreur mesurés, des signaux de correction sont délivrés et ajoutés aux signaux démodulés.

Par ailleurs, il est connu que dans un appareil de réception, un inconvénient réside dans l'existence d'un délai de réaction dans la boucle de récupération de porteuse, délai qui s'écoule entre l'instant d'apparition du signal d'entrée à l'entrée de l'appareil et l'instant où arrivent les signaux d'entrée traités, nécessaires au fonctionnement du détecteur phase/fréquence. Ce délai, qui peut être long, est dû au traitement du signal effectué sur le signal d'entrée tels que la démodulation, le filtrage, l'égalisation, les étapes de décision. L'existence d'un tel délai conduit à choisir les paramètres d'une boucle de récupération de porteuse en effectuant des compromis entre différentes contraintes du système. Un tel compromis est par exemple fait entre, d'une part, la valeur maximale admissible de la gigue de phase, et entre, d'autre part, la valeur minimale de la fréquence naturelle de la boucle, fréquence qui intervient sur l'étendue du domaine d'acquisition et sur la robustesse de la boucle vis-à-vis des bruits de phase créés, entre autres, par des effets microphoniques.

Le but de l'invention est donc de satisfaire le mieux possible ces différentes exigences.

Ce but est atteint avec un système de transmission tel que défini dans la partie introductive de la description pour lequel la seconde boucle des moyens de synchronisation de porteuse de l'appareil de réception comprend en outre :

a) des seconds moyens de filtrage passe-bas pour filtrer le second signal d'erreur, les seconds moyens de filtrage ayant une bande passante plus étendue que la première bande passante pour faire que la synchronisation soit robuste à des bruits de phase,

b) des moyens pour transformer le second signal d'erreur, après l'avoir filtré par les seconds moyens de filtrage, en le signal (E3) de correction de phase,
c) les moyens de détection de phase étant connectés en sortie des moyens de traitement.

Le but de l'invention est également atteint avec un appareil de réception tel que défini dans la revendication 5.

La première boucle est en partie analogique avec les moyens de détection phase/fréquence réalisés sous forme numérique. La fréquence naturelle de la première boucle doit être suffisamment basse pour absorber le délai du traitement du signal d'entrée mais néanmoins être suffisamment élevée pour garantir la récupération de la fréquence.

La seconde boucle est préférentiellement complètement numérique mais elle peut être aussi analogique. Elle peut être programmable. Sa fréquence naturelle doit être supérieure à la fréquence naturelle de la première boucle de façon à être apte à suivre les corrections imposées par la première boucle.

Dans le cas où les deux boucles possèdent un filtrage opéré numériquement, pour tenir compte des défauts de linéarité de la conversion analogique-numérique, on fait intervenir un coefficient de fuite dans le fonctionnement du filtre numérique de la seconde boucle. Le second filtre numérique comprend alors :

- un premier additionneur ayant une première entrée pour recevoir le second signal d'erreur, une sortie délivrant un signal de sortie, une seconde entrée qui est réunie à la sortie à travers un circuit en boucle, le circuit en boucle comprenant, en série, un moyen de retard et un moyen de pondération appliquant un coefficient de fuite au signal de sortie retardé,
- un second additionneur qui additionne le second signal d'erreur avec le signal de sortie du premier additionneur pour délivrer un signal d'erreur filtré.

En mode accroché, la première boucle et la seconde boucle utilisent le même signal d'erreur issu du même détecteur de phase. Ainsi avantageusement, on évite de faux accrochages en mode accroché. Les différences de phase entre les deux boucles restent ainsi constantes, ce qui permet aux deux boucles d'être toujours placées simultanément dans le même mode soit accroché/soit décroché.

Ces différents aspects de l'invention et d'autres encore seront apparents et élucidés à partir des modes de réalisation décrits ci-après.

L'invention sera mieux comprise à l'aide des figures suivantes données à titre d'exemples non limitatifs qui représentent :

Figure 1 : un schéma de l'appareil de réception muni des deux boucles de correction selon l'invention.
Figure 2 : un schéma d'un mode de réalisation de l'oscillateur numérique.
Figure 3 : un schéma de réalisation d'un filtre numérique.
Figure 4 : un schéma d'un exemple de réalisation des moyens de transformation du signal d'erreur $\varepsilon 2$ en des valeurs de phase $\phi$.
Figure 5 : un schéma général d'un système de transmission.
Figures 6A, 6B : des schémas de deux configurations de réalisation des moyens de commutation permettant de faire fonctionner les deux boucles.
Figure 7 : un schéma d'un filtre disposé dans la seconde boucle modifié pour tenir compte de défauts de linéarité d'une conversion numérique/analogique.

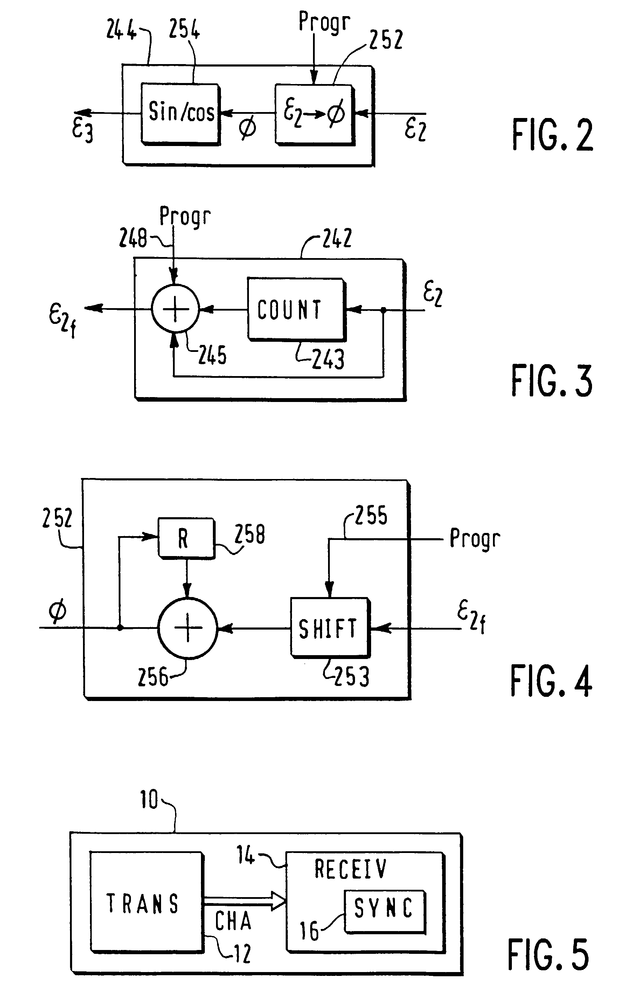

La figure 5 représente un schéma d'un système 10 de transmission de signaux numériques qui comprend un émetteur 12 qui envoie des données codées par modulation numérique vers un récepteur 14. La transmission est effectuée à travers un canal CHA. Le récepteur comprend des moyens 16 de synchronisation SYNC pour synchroniser une porteuse locale sur la porteuse de l'émetteur 12.

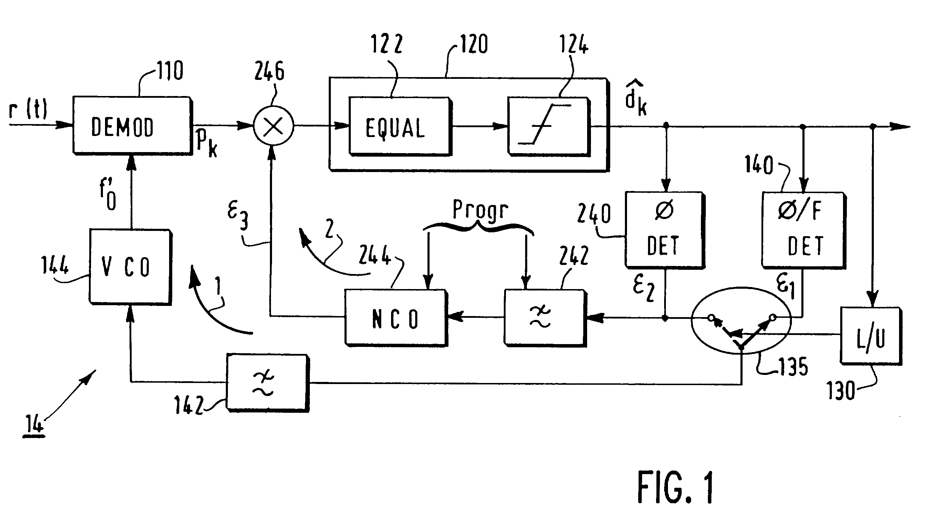

La figure 1 représente un schéma du récepteur 14 selon un mode préférentiel de réalisation de l'invention. Le signal r(t), reçu en fréquence intermédiaire FI, est échantillonné puis démodulé dans un démodulateur 110 pour fournir un signal $p_k$ formé d'une composante I en phase et d'une composante Q en quadrature avec la porteuse. L'indice k est le numéro d'échantillon. Des moyens de traitement 120 effectuent un traitement du signal $p_k$ pour fournir des symboles $\hat{d}_k$ estimant les symboles $d_k$ d'une modulation codée utilisée à l'émission. Les moyens de traitement 120 comprennent des moyens 124 de décision précédés, si cela est nécessaire, de moyens 122 d'égalisation.

Les moyens de récupération de porteuse sont utilisés pour établir une synchronisation en fréquence et en phase de l'oscillateur local avec la porteuse à fréquence intermédiaire. Dans le cas où des écarts de fréquence apparaissent entre les fréquences des deux porteuses, et dans la mesure où cet écart de fréquence est compatible avec le domaine de capture des moyens de récupération de porteuse, ceux-ci imposent à la fréquence de l'oscillateur local de devenir identique à la fréquence de la porteuse FI, ce qui fait passer les moyens de récupération de porteuse d'un mode d'accrochage (U) à un mode accroché (L). Lorsque la fréquence de l'oscillateur local est accrochée, les moyens de récupération de porteuse opèrent ensuite une synchronisation de phase entre les deux porteuses.

Pour mettre en jeu ces deux modes de fonctionnement, les moyens de récupération de porteuse comportent une première boucle 1 qui intervient, au cours du mode d'accrochage, pour l'accrochage en fréquence, et une seconde boucle 2 qui intervient ensuite, au cours du mode accroché, pour la synchronisation de phase pour compléter les corrections de défauts de synchronisation effectuées par la première boucle. Le signal d'erreur du détecteur de phase sert alors aux deux boucles.

Au cours du mode d'accrochage, la première boucle comporte un détecteur 140 phase/fréquence qui délivre le premier signal d'erreur $\varepsilon 1$ qui est filtré par un premier filtre 142 passe-bas de boucle, le premier signal d'erreur ainsi filtré commandant un oscillateur 144 VCO commandé en tension. L'oscillateur 144 délivre une porteuse locale $f_o^{'}$ qu'il maintient synchronisée avec la porteuse du signal à fréquence intermédiaire.

Lorsque l'oscillateur local a ainsi été accroché en fréquence et éventuellement imparfaitement en phase, il est généralement nécessaire de parfaire la synchronisation de phase car la gigue de phase peut être importante. Ceci est effectué selon l'invention à l'aide de la seconde boucle 2 qui comprend un détecteur 240 de phase qui délivre le second signal d'erreur ε2 qui est filtré par un second filtre 242 passe-bas de boucle. La bande passante du second filtre doit couvrir des fréquences plus élevées de celles couvertes par le premier filtre. Le second signal d'erreur ε2, après filtrage, constitue une commande pour un oscillateur numérique 244 qui fournit un signal ε3 de correction de phase. Un mélangeur 246, placé entre le démodulateur 110 et les moyens 120 de traitement, mélange le signal échantillonné $p_k$ avec le signal ε3 de correction de phase pour corriger la phase du signal $p_k$. Le signal $p_k$ étant formé d'une composante en phase et d'une composante en quadrature, il s'ensuit que le signal ε3 de correction de phase est lui aussi formé de deux composantes en quadrature l'une par rapport à l'autre.

Le détecteur phase/fréquence 140 et le détecteur de phase 240 sont connectés à une sortie des moyens de traitement 120. Ils peuvent être connectés soit en sortie des moyens 124 de décision, soit en sortie des moyens 122 d'égalisation. Les détecteurs 140, 240 opèrent numériquement.

Le démodulateur 110, le mélangeur 246 et les moyens de traitement 120 réalisent préférentiellement un traitement numérique. Néanmoins, il est possible que tous ou certains de ces éléments réalisent un traitement analogique, auquel cas des moyens d'échantillonnage peuvent alors être disposés soit en sortie respectivement du démodulateur 110, du mélangeur 246 ou des moyens de traitement 120 pour obtenir un fonctionnement mixte analogique-numérique.

La première boucle 1 doit avoir une fréquence naturelle assez basse pour tolérer les délais de traitement dus au traitement effectué, mais néanmoins être suffisamment élevée pour assurer la récupération du décalage maximal de fréquence que l'on désire couvrir. Ceci permet au système de faire face aux bruits d'origine microphonique.

La fréquence naturelle d'une boucle est déterminée par les constantes de temps du filtre de boucle, le gain du VCO, le gain statique du détecteur de phase. De cette fréquence naturelle découle la bande de bruit de la boucle.

La seconde boucle 2 doit avoir une fréquence naturelle plus élevée que celle de la première boucle 1 de manière à permettre à la seconde boucle de compléter les corrections imposées par la première boucle.

Lorsque l'oscillateur 144 est accroché (mode L), un détecteur de mode L/U 130 active des moyens de commutation 135 qui connectent le premier filtre 142 sur la sortie du détecteur de phase 240 pour faire fonctionner la première boucle 1 avec le signal d'erreur de phase ε2 délivré par le détecteur de phase 240. Ainsi en utilisant le même détecteur de phase dans les deux boucles, on évite les conflits d'accrochages, les corrections imposées par les boucles 1 et 2 étant toujours en phase.

L'oscillateur numérique NCO 244 placé dans la seconde boucle peut être programmé à l'aide d'une commande PROGR pour modifier la fréquence naturelle de la boucle.

Préférentiellement, l'oscillateur numérique 244 (figure 2) comprend des moyens de conversion 252 qui transforment le signal ε2 d'erreur de phase (après filtrage) en valeurs de phase ɸ qui servent à adresser des moyens 254 de génération de valeurs du signal de correction ε3 sous la forme de valeurs de sinus/cosinus de la phase ɸ. Les moyens 254 peuvent être constitués d'une table de lecture stockée par exemple dans une mémoire.

Selon un mode particulier de réalisation, les moyens 242 de filtrage de la deuxième boucle comprennent (figure 3) un compteur/décompteur 243 COUNT qui accumule des valeurs du signal de phase ε2 (ε2 pouvant prendre des valeurs -1, 0 ou +1). La sortie du compteur 243 est ajoutée dans un additionneur 245 à la valeur courante du signal de phase ε2. La sortie de l'additionneur 245 délivre un signal filtré $\varepsilon2_f$. L'additionneur 245 dispose d'une entrée supplémentaire 248 qui lui permet de recevoir des valeurs de programmation PROGR pour modifier les caractéristiques des moyens de filtrage 242.

La figure 4 représente un exemple de réalisation des moyens 252 de transformation des erreurs de phase en valeurs de phase. Le signal filtré $\varepsilon2_f$ entre dans des moyens de décalage 253 SHIFT qui possèdent une autre entrée 255 pour recevoir une valeur de programmation PROGR pour modifier les caractéristiques des moyens 252 de transformation. La sortie des moyens de décalage entre dans des moyens d'accumulation qui cumulent une suite de valeurs du signal filtré $\varepsilon2_f$. Les moyens d'accumulation comprennent, connectés en boucle fermée, un additionneur 256 et un registre 258. La sortie de l'additionneur 256 délivre les valeurs successives de phase ɸ qui servent à adresser les moyens 254 qui génèrent les deux composantes en quadrature du signal de correction ε3.

Le premier filtre 142 peut être analogique ou numérique, d'où la nécessité d'effectuer une conversion numérique/ analogique soit avant, soit après le premier filtre 142. Dans le cas où cette conversion est effectuée avant le premier filtre 142, il peut être utile de tenir compte des défauts de linéarité qu'engendrent une conversion opérée de la sorte pour éviter des glissements de fréquence d'accrochage de l'oscillateur 144. Ceci est une conséquence du fait que, dans le cas où le premier filtre est un intégrateur parfait ou presque parfait, celui-ci va accumuler peu à peu les défauts de linéarité qui apparaissent, dans la boucle 1, sous forme de composantes continues de faible amplitude qui viennent s'additionner au signal d'erreur délivré par le détecteur de phase/fréquence 140 ou le détecteur de phase 240. Il s'agit, par exemple, d'une tension résiduelle sur la sortie du convertisseur numérique/analogique en l'absence de signal sur l'entrée. Ceci constitue un dysfonctionnement provoquant des glissements de fréquence qu'il faut alors compenser en agissant sur la boucle 2.

Pour compenser les glissements de fréquence, on agit sur le second filtre 242. Pour cela, on fait intervenir un coefficient de fuite α dans le fonctionnement du second filtre 242 passe-bas de boucle. En donnant à ce coefficient de fuite α une valeur inférieure à 1, par exemple 1-1/32, on garantit que la poursuite du suivi de la phase ne sera pas réalisée essentiellement par la boucle 2, et donc que la boucle 1 sera en mesure de compenser les écarts de fréquence, la boucle 2 étant plus rapide à réagir que la boucle 1.

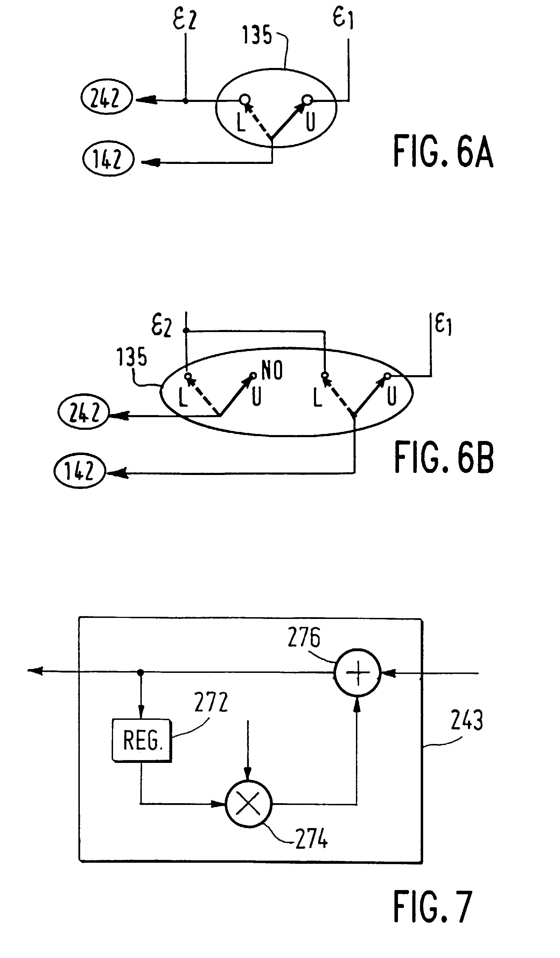

Ce coefficient de fuite a ne se justifie que dans le cas où la conversion numérique/analogique est effectuée avant le premier filtre 142. Dans la pratique, ceci est obtenu en donnant au compteur 243 la structure de la figure 7. Le compteur 243 comprend alors un additionneur 276 ayant une première entrée qui reçoit le signal ε2 et une sortie qui est réunie à un circuit en boucle qui comprend un registre 272 qui stocke, au cours d'un cycle, la valeur de sortie de l'additionneur 276, cette valeur retardée est délivrée à un multiplieur 274 qui multiplie cette valeur par le coefficient de fuite a pour délivrer une valeur corrigée qui est appliquée à la seconde entrée de l'additionneur 276.

Les première et seconde boucles peuvent recevoir des signaux différents selon que les moyens de synchronisation de porteuse sont en mode d'accrochage (U) ou en mode accroché (L). Le tableau I suivant résume différentes possibilités.

|  | U | | L |
| --- | --- | --- | --- |
| 1ère boucle | ε1 | | ε2 |
| 2ème boucle | NO | ε2 | ε2 |

Les figures 6A, 6B représentent différentes manières d'effectuer les commutations à l'aide des moyens de commutation 135.

La figure 6A représente le mode préférentiel de la figure 1 pour lequel on a :

| mode U | 1ère boucle | ε1 |
| --- | --- | --- |
| | 2ème boucle | ε2 |
| mode L | 1ère boucle | ε2 |
| | 2ème boucle | ε2 |

Pour la figure 6 B :

| mode U | 1ère boucle | ε1 |
| --- | --- | --- |
| | 2ème boucle | NO |
| mode L | 1ère boucle | ε2 |
| | 2ème boucle | ε2 |

pour laquelle "NO" signifie que la deuxième boucle est non-opérante en mode d'accrochage.

**Revendications**

1. Système (10) de transmission de signaux muni d'un appareil (14) de réception comprenant des moyens de synchronisation de porteuse pour estimer et compenser des défauts de synchronisation entre une porteuse locale et un signal d'entrée modulé, l'appareil comprenant en outre des moyens (110) de démodulation du signal d'entrée qui délivrent un signal démodulé et des moyens (120) de traitement du signal démodulé, les moyens de synchronisation comprenant une première boucle (1) de correction munie d'une part de moyens (140) de détection phase/fréquence pour délivrer un premier signal d'erreur (ε1), des premiers moyens (142) de filtrage passe-bas ayant une première bande passante pour filtrer le premier signal d'erreur, le premier signal d'erreur filtré corrigeant les défauts de synchronisation en mode d'accrochage, et d'autre part de moyens (144) pour générer la porteuse locale, et une deuxième boucle (2) de correction comprenant des moyens (240) de détection de phase qui délivrent un second signal d'erreur ($\epsilon$2) lequel corrige les défauts de synchronisation en mode accroché, des moyens de mixage (246), disposés entre les moyens (110) de démodulation et les moyens (120) de traitement, pour mélanger le signal démodulé avec un signal ($\epsilon$3) de correction de phase, et des moyens (130) (135) pour commander les boucles (1) (2) et pour placer les moyens de synchronisation soit en mode d'accrochage, soit en mode accroché, caractérisé en ce que la seconde boucle (2) comprend en outre:

a) des seconds moyens (242) de filtrage passe-bas pour filtrer le second signal d'erreur ($\epsilon$2), les seconds moyens de filtrage ayant une bande passante plus étendue que la première bande passante pour faire que la synchronisation soit robuste à des bruits de phase,

b) des moyens (244) pour transformer le second signal d'erreur, après l'avoir filtré par les seconds moyens (242) de filtrage, en le signal ($\epsilon$3) de correction de phase,

c) les moyens de détection (240) de phase étant connectés en sortie des moyens de traitement (120).

2. Système selon la revendication 1 caractérisé en ce que les premiers moyens (142) de filtrage passe-bas et les seconds moyens (242) de filtrage passe-bas sont des filtres numériques, le second filtre comprenant :

- un premier additionneur (276) ayant une première entrée pour recevoir le second signal d'erreur, une sortie délivrant un signal de sortie, une seconde entrée qui est réunie à la sortie à travers un circuit en boucle, le circuit en boucle comprenant, en série, un moyen de retard (272) et un moyen de pondération (274) appliquant un coefficient de fuite au signal de sortie retardé,
- un second additionneur (245) qui additionne le second signal d'erreur avec le signal de sortie du premier additionneur (276) pour délivrer un signal d'erreur filtré.

3. Système selon les revendications 1 ou 2 caractérisé en ce que les moyens (244) pour transformer le second signal d'erreur en signal ($\epsilon$3) de correction de phase comprennent des moyens de conversion (252) qui transforment le signal ($\epsilon$2) d'erreur en un signal de phase ($\phi$) et des moyens (254) pour générer deux composantes sinus/cosinus du signal de phase ($\phi$),les composantes formant le signal ($\epsilon$3) de correction de phase.

4. Système selon la revendication 3 caractérisé en ce que les moyens (254) pour générer les deux composantes sinus/cosinus comprennent une mémoire qui stocke une table de lecture.

5. Appareil (14) de réception comprenant des moyens de synchronisation de porteuse pour estimer et compenser des défauts de synchronisation entre une porteuse locale et un signal d'entrée modulé, l'appareil comprenant en outre des moyens (110) de démodulation du signal d'entrée qui délivrent un signal démodulé et des moyens (120) de traitement du signal démodulé, les moyens de synchronisation comprenant une première boucle (1) de correction munie d'une part de moyens (140) de détection phase/fréquence pour délivrer un premier signal d'erreur ($\epsilon$1), des premiers moyens (142) de filtrage passe-bas ayant une première bande passante pour filtrer le premier signal d'erreur, le premier signal d'erreur filtré corrigeant les défauts de synchronisation en mode d'accrochage, et d'autre part de moyens (144) pour générer la porteuse locale, et une deuxième boucle (2) de correction comprenant des moyens (240) de détection de phase qui délivrent un second signal d'erreur ($\epsilon$2) lequel corrige les défauts de synchronisation en mode accroché, des moyens de mixage (246), disposés entre les moyens (110) de démodulation et les moyens (120) de traitement, pour mélanger le signal démodulé avec un signal ($\epsilon$3) de correction de phase, et des moyens (130) (135) pour commander les boucles (1) (2) et pour placer les moyens de synchronisation soit en mode d'accrochage, soit en mode accroché, caractérisé en ce que la seconde boucle (2) comprend en outre:

a) des seconds moyens (242) de filtrage passe-bas pour filtrer le second signal d'erreur ($\epsilon$2), les seconds moyens de filtrage ayant une bande passante plus étendue que la première bande passante pour faire que la synchronisation soit robuste à des bruits de phase,

b) des moyens (244) pour transformer le second signal d'erreur, après l'avoir filtré par les seconds moyens (242) de filtrage, en le signal ($\epsilon$3) de correction de phase,

c) les moyens de détection (240) de phase étant connectés en sortie des moyens de traitement (120).

6. Utilisation d'un appareil de réception selon la revendication 5 dans un système de transmission numérique.

**EP 0 698 970 B1**

**Patentansprüche**

1. Signal-Übertragungssystem (10), versehen mit einem Empfangsgerät mit Mitteln zur Träger-Synchronisation, um Synchronisationsfehler zwischen eines lokalen Trägers und einem modulierten Eingangssignal bewerten und ausgleichen zu können, das Gerät enthält außerdem Mittel (110) zur Demodulation des Eingangssignal, das ein demoduliertes Signal abgibt, und Mittel (120) zur Verarbeitung des demodulierten Signals, die Synchronisationsmittel enthalten eine erste Korrekturschleife (1), einerseits mit Mitteln (140) zur Erkennung Phase/Frequenz versehen, um ein erstes Fehlersignal ($\varepsilon$1) abzugeben, erste Tiefpaß-Filtermittel (142) mit einer ersten Bandbreite zur Filterung des ersten Fehlersignals, wobei das erste gefilterte Fehlsignal die Synchronisationsfehler in einschwingendem Modus korrigiert, und andererseits Mittel (144) zur Erzeugung des lokalen Trägers, und eine zweite Korrekturschleife (2) mit Phasenerkennungsmitteln (240), die ein zweites Fehlersignal ($\varepsilon$2) abgeben, das die Synchronisationsfehler in eingeschwungenem Modus korrigiert, Mischmittel (246), angeordnet zwischen den Demodulationsmitteln (110) und den Verarbeitungsmitteln (120), um das demodulierte Signal ($\varepsilon$3) mit einem Phasen-Korrektursignal zu mischen, und Mittel (130)(135) zur Steuerung der Schleifen (1)(2) und zur Anordnung der Synchronisationsmittel entweder in einschwingendem oder eingeschwungenem Modus, dadurch gekennzeichnet, daß die zweite Schleife (2) außerdem enthält:

   a) zweite Tiefpaß-Filtermittel (242) zur Filterung des zweiten Fehlersignals ($\varepsilon$2), wobei die zweiten Filtermittel eine über der ersten Bandbreite liegende Bandbreite haben, um die Synchronisation gegenüber Phasengeräuschen stabil zu machen,
   b) Mittel (244) zur Umwandlung des zweiten Fehlersignals, nachdem es von den zweiten Filtermitteln (242) gefiltert wurde, in das Phasen-Korrektursignal ($\varepsilon$3),
   c) Phasen-Erkennungsmittel (240), am Ausgang mit den Verarbeitungsmitteln (120) verbunden.

2. System nach Anspruch 1, dadurch gekennzeichnet, daß die ersten Tiefpaß-Filtermittel (142) und die zweiten Tiefpaß-Filtermittel (242) digitale Filter sind, der zweite Filter besteht aus:

   - einem ersten Addierer (276) mit einem ersten Eingang für den Empfang des zweiten Fehlersignals, wobei ein Ausgang ein Ausgangssignal liefert, einen zweiten Eingang, der über eine Schleifenschaltung mit dem Ausgang verbunden ist, die Schleifenschaltung enthält in Serie ein Verzögerungsmittel (272) und ein Bewertungsmittel (274) zur Zuführung eines Verlustkoeffizienten an das verzögerte Ausgangssignal,
   - einen zweiten Addierer (245) zum addieren des zweiten Fehlersignals mit dem Ausgangssignal des ersten Addierers (276), um ein gefiltertes Fehlersignal abzugeben.

3. System nach den Ansprüchen 1 oder 2, dadurch gekennzeichnet, daß die Mittel (244) zum Umwandeln des zweiten Fehlersignals in ein Phasen-Korrektursignal ($\varepsilon$3) Konvertierungsmittel (252) zum Umwandeln des Fehlersignals ($\varepsilon$2) in ein Phasensignal ($\phi$) und Mittel (254) zur Erzeugung zweier Komponenten Sinus/Kosinus des Phasensignals $\phi$ aufweisen, die Komponenten bilden das Phasen-Korrektursignal ($\varepsilon$3).

4. System nach Anspruch 3, dadurch gekennzeichnet, daß die Mittel (254) zur Erzeugung der beiden Komponenten Sinus/Kosinus einen Speicher zum speichern einer Lesetabelle enthalten.

5. Empfangsgerät (14) mit Mitteln zur Träger-Synchronisation, um Synchronisationsfehler zwischen einem lokalen Träger und einem modulierten Eingangssignal bewerten und ausgleichen zu können, das Gerät enthält außerdem Mittel (110) zur Demodulation des Eingangssignal, das ein demoduliertes Signal abgibt, und Mittel (120) zur Verarbeitung des demodulierten Signals, die Synchronisationsmittel enthalten eine erste Korrekturschleife (1), einerseits mit Mitteln (140) zur Erkennung Phase/Frequenz versehen, um ein erstes Fehlersignal ($\varepsilon$1) abzugeben, erste Tiefpaß-Filtermittel (142) mit einer ersten Bandbreite zur Filterung des ersten Fehlersignals, wobei das erste gefilterte Fehlersignal die Synchronisationsfehler in einschwingendem Modus korrigiert, und andererseits Mittel (144) zur Erzeugung des lokalen Trägers, und eine zweite Korrekturschleife (2) mit Phasenerkennungsmitteln (240), die ein zweites Fehlersignal ($\varepsilon$2) abgeben, das die Synchronisationsfehler in eingeschwungenem Modus korrigiert, Mischmittel (246), angeordnet zwischen den Demodulationsmitteln (110) und den Verarbeitungsmitteln (120), um das demodulierte Signal ($\varepsilon$3) mit einem Phasen-Korrektursignal zu mischen, und Mittel (130)(135) zur Steuerung der Schleifen (1)(2) und zur Anordnung der Synchronisationsmittel entweder in einschwingendem oder eingeschwungenem Modus, dadurch gekennzeichnet, daß die zweite Schleife (2) außerdem enthält:

   a) zweite Tiefpaß-Filtermittel (242) zur Filterung des zweiten Fehlersignals ($\varepsilon$2), wobei die zweiten Filtermittel eine über der ersten Bandbreite liegende Bandbreite haben, um die Synchronisation gegenüber Phasenge-

7

räuschen stabil zu machen,
b) Mittel (244) zur Umwandlung des zweiten Fehlersignals, nachdem es von den zweiten Filtermitteln (242) gefiltert wurde, in das Phasen-Korrektursignal ($\varepsilon$3),
c) Phasen-Erkennungsmittel (240), am Ausgang mit den Verarbeitungsmitteln (120) verbunden.

6. Verwendung eines Empfangsgeräts nach Anspruch 5 in einem digitalen Übertragungsgerät.


**Claims**

1. A signal transmission system (10) comprising a receiving device (14) which includes carrier synchronizing means for estimating and compensating synchronization errors between a local carrier and a modulated input signal, while the device further includes input signal demodulation means (110) which produce a demodulated signal, and processing means (120) for processing the demodulated signal, the synchronizing means comprising a first correction loop (1) which includes, on the one hand, phase/frequency detection means (140) for producing a first error signal ($\varepsilon$1), first low-pass filter means having a first passband for filtering the first error signal, which first filtered error signal corrects the synchronization errors in the unlocked mode, and, on the other hand, means (144) for generating the local carrier, and a second correction loop (2) which includes phase detection means (240) which produce a second error signal ($\varepsilon$2) which corrects the synchronization errors in the locked mode, mixing means (246), arranged between the demodulation means (110) and the processing means (120), for mixing the demodulated signal with a phase corrected signal ($\varepsilon$3), and means (130, 135) for controlling the loops (1, 2) and for putting the synchronizing means either in the unlocked mode or in the locked mode, characterized in that the second loop (2) further includes:

   a) second low-pass filter means (242) for filtering the second error signal ($\varepsilon$2), the second filter means having a passband which is wider than the first passband to achieve that the synchronization is robust to phase noise,
   b) transforming means (244) for transforming the second error signal into the phase correction signal ($\varepsilon$3) after the second error signal has been filtered by the second filter means (242),
   c) while the phase detection means (240) are connected to the output of the processing means (120).

2. The system as claimed in claim 1, characterized in that the first low-pass filter means (142) and the second low-pass filter means (242) are digital filters, while the second digital filter comprises:

   - a first adder (276) which has a first input for receiving the second error signal, an output which delivers an output signal, a second input which is connected to the output across a loop circuit, while the loop circuit comprises, in a series combination, a delay means (272) and a weighting means (274) applying a leakage factor to the delayed output signal,
   - a second adder (245) which adds the second error signal to the output signal of the first adder (276) to deliver a filtered error signal.

3. The system as claimed in Claim 1 or 2, characterized in that the means (244) for transforming the second error signal into a phase correction signal ($\varepsilon$3) comprise converting means (252) which convert the error signal ($\varepsilon$2) into a phase signal ($\phi$) and means (254) for generating two sine/cosine components of the signal having phase ($\phi$), the components forming the phase correction signal ($\varepsilon$3).

4. The system as claimed in Claim 3, characterized in that the means (254) for generating the two sine/cosine components comprise a memory that stores a look-up Table.

5. A receiving device (14) which includes carrier synchronizing means for estimating and compensating synchronization errors between a local carrier and a modulated input signal, the device further including input signal demodulation means (110) which produce a demodulated signal, and processing means (120) for processing the demodulated signal, the synchronizing means comprising a first correction loop (1) which includes, on the one hand, phase/frequency detection means (140) for producing a first error signal ($\varepsilon$1), first low-pass filter means (142) having a first passband for filtering the first error signal, which first filtered error signal corrects the synchronization errors in the unlocked mode, and, on the other hand, means (144) for generating the local carrier, and a second correction loop (2) which includes phase detection means (240) which produce a second error signal ($\varepsilon$2) which corrects the synchronization errors in the locked mode, mixing means (246), arranged between the demodulation means (110) and the processing means (120), for mixing the demodulated signal with a phase corrected signal

($\epsilon$3), and means (130, 135) for controlling the loops (1, 2) and for putting the synchronizing means either in the unlocked mode or in the locked mode, characterized in that the second loop (2) further includes:

    a) second low-pass filter means (242) for filtering the second error signal ($\epsilon$2), the second filter means having a passband which is wider than the first passband to achieve that the synchronization is robust to phase noise,
    b) transforming means (244) for transforming the second error signal into the phase correction signal ($\epsilon$3) after the second error signal has been filtered by the second filter means (242),
    c) while the phase detection means (240) are connected to the output of the processing means (120).

6. A use of a receiving device as claimed in claim 5 in a digital transmission system.

FIG. 1

EP 0 698 970 B1

FIG. 2

FIG. 3

FIG. 4

FIG. 5

FIG. 6A

FIG. 6B

FIG. 7